(19) Europäisches Patentamt

European Patent Office

Office européen des brevets

(11) **EP 0 588 181 B1**

(12) **EUROPEAN PATENT SPECIFICATION**

(45) Date of publication and mention
of the grant of the patent:
**15.11.2000 Bulletin 2000/46**

(51) Int. Cl.⁷: $G06T\ 5/20$, $H03H\ 17/02$, $H04N\ 5/21$

(21) Application number: **93114130.3**

(22) Date of filing: **03.09.1993**

(54) **Method and apparatus for noise reduction**

Verfahren und Gerät zur Rauschminderung

Méthode et appareil de réduction de bruit

(84) Designated Contracting States:
**DE ES FR GB IT**

(30) Priority: **14.09.1992 EP 92402502**

(43) Date of publication of application:
**23.03.1994 Bulletin 1994/12**

(73) Proprietor: **THOMSON multimedia**
**92648 Boulogne Cédex (FR)**

(72) Inventors:
• **Heimburger, Catherine**
**F-67000 Strasbourg (FR)**
• **Knee, Michael**
**F-67400 Illkirch (FR)**

(74) Representative:
**Hartnack, Wolfgang, Dipl.-Ing. et al**
**Deutsche Thomson-Brandt GmbH**
**European Patent Operations**
**Karl-Wiechert-Allee 74**
**30625 Hannover (DE)**

(56) References cited:
**US-A- 4 334 244**

• **SIGNAL PROCESSING. EUROPEAN JOURNAL DEVOTED TO THE METHODS AND APPLICATIONS OF SIGNAL PROCESSING vol. 20, no. 1, May 1990, AMSTERDAM NL pages 3 - 14 UNSER 'Improved restoration of noisy images by adaptive least-squares post-filtering'**
• **IEEE TRANSACTIONS ON ACOUSTICS, SPEECH, AND SIGNAL PROCESSING vol. 37, no. 8, August 1989, NEW YORK US pages 1293 - 1298 KUNDU ET AL. 'Double.window Hodges-Lehman (D) filter and hybrid D-median filter for robust image smoothing'**

**Description**

The present invention relates to a method and to an apparatus for noise reduction.

Background

Different kinds of video noise filters are known. M. Unser, "Improved restoration of noisy images by adaptive least-squares post-filtering", Signal Processing 20 (1990), pp. 3-14, gives an example. Normally such filters need a certain amount of memory, e.g. field memories, or are not suited for every noise level or are not adaptive to the local structure of the picture.

Invention

It is one object of the invention to disclose a method for noise reduction, which does need only simple hardware and takes into account different noise levels and picture structures. This object is reached by the method disclosed in claim 1.

It is a further object of the invention to disclose an apparatus which utilises the inventive method. This object is reached by the apparatus disclosed in claim 9.

For the inventive noise reduction the main requirements listed below are considered:

* field processing i.e. without field memory;
* few memories and simple hardware realisation;
* processing adaptive to any level of noise;
* processing adaptive to the local structure of the picture,

i.e. detecting plain areas, edges and fine details so as to preserve the relevant information of the picture.

Different filters could be used:

1. linear low pass filter with different coefficients;
2. median filter;
3. linear filter in the direction of the edges (directional filter);
4. directional median filter;
5. weighted averages of filters 1, 2, 3 and 4;
6. filtering with one of the filters 1, 2, 3 and 4 with fixed threshold and local measure of picture activity by the Laplacian.

These filter types have the following properties:

* median filters are more suitable to remove noise in plain areas than linear filters especially in the case of high frequency noise of high amplitude;
* median filters preserve edges and linear filters do not;
* directional filters are very efficient for preserving edges and picture accuracy while filtering slightly but efficiently enough;
* median filters completely lose the fine textures (of a zone plate test picture, for example) and the only way to preserve them is to use a directional filter;
* weighted averages of filters give good results but the weighting coefficients are not easy to adapt locally without correct noise estimation and can lead to hard switching and to the introduction of artefacts;
* thresholds and local measures of activity give good results when adapted to the picture but they have to be combined with noise estimation on the whole picture.

The inventive solution is globally and locally adaptive. The implemented filter is derived from that proposed by Unser (cited above) and works as follows:
The noisy input signal x is filtered with a restoration filter of median type to generate a filtered input signal y. The sum of the absolute differences between filtered and unfiltered signal is calculated for each position of a sliding window within the input signal, representing a local estimate of the noise, and is combined with a global measure of the input signal noise to compute by least squares regression two coefficients a and b which are respectively applied to the unfiltered and filtered signal to generate the output signal $z = a*x + b*y$.

Advantageously the only required prior information is the noise variance $\sigma^2$, assuming that the original signal

$\mu$ is degraded by additive stationary noise n. The size of the local noise estimation window can be different from the size of the window used by the restoration filter, wherefore they can be adjusted independently for optimal performance.

The weighting coefficients a and b are made optimal in the sense that they are minimising the quadratic error $\varepsilon^2$ between the output signal z and the noise free original signal $\mu$. It is true that the original signal is not known at a receiver, but global noise statistics can be calculated at the receiver side (e.g. described in EP-A-92400785) and used for that optimisation. Preferably a+b = 1 , so that no bias is introduced by the filtering. This solution usually performs slightly worse, but is rather simple to implement, no computational complexity need be added.

If the filtering tends to degrade the signal, a predominant weight will be given to the unfiltered signal x. Conversely, when the sum of differences is small and close to a reference value corresponding to the residue of the noise alone, the weight will be shifted to the filtered signal.

The choice of the kind of restoration filter does heavily influence the merit of the inventive noise reduction. Therefore, advantageously different kind of filters can operate in parallel, whereby the kind of filter elected has to be locally adapted to the picture activity. That branch which results in a minimum error between the filtered and the unfiltered signal will be selected.

An inventive method and apparatus in accordance with claims 1 and 7 is proposed.

Advantageous additional embodiments of the inventive apparatus are resulting from the respective dependent claims.

<u>Drawings</u>

Preferred embodiments of the invention are described with reference to the accompanying drawings, which show in:

Fig. 1    first embodiment of an inventive noise reduction circuit;
Fig. 2    filter-related directions in the picture;
Fig. 3    window for noise filtering;
Fig. 4    second embodiment of an inventive noise reduction circuit;
Fig. 5    correction terms for the comparison of the filters errors.

<u>Preferred embodiments</u>

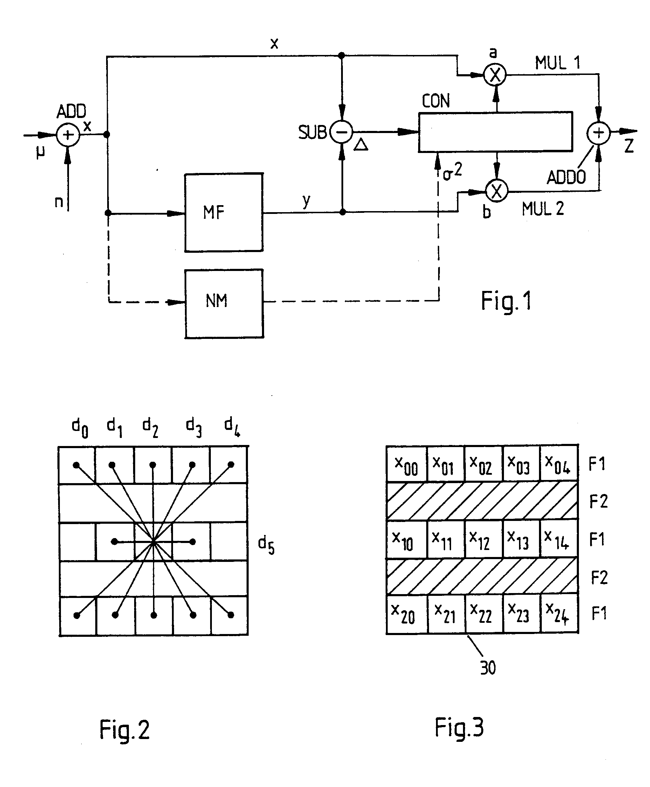

In Fig. 1 noise n is added in a channel, e.g. a TV channel, to a noise free original signal $\mu$, e.g. a TV signal. The resulting noisy input signal x of the inventive apparatus, e.g. in a TV receiver or a VCR, is filtered with a restoration filter MF of median type to generate a filtered input signal y. The difference $\Delta$ between signal x and signal y is calculated in a subtractor SUB and fed to a control circuit CON which forms from $\Delta$ the sum of the absolute differences between filtered and unfiltered input signal for each position of a sliding window within the input signal x, representing a local estimate of the noise.

The global noise statistics can be calculated in a noise measurement circuit NM. The local noise estimate is combined in control circuit CON with the global measure $\sigma^2$ of the input signal noise to compute by least squares regression two coefficients a and b which are respectively applied to the unfiltered and filtered signal to generate the output signal z = a*x + b*y . This can be done by multiplying signal x in a first multiplier MUL1 by factor a and by multiplying signal y in a second multiplier MUL2 by factor b. The outputs of MUL1 and MUL2 are added in adder ADD0, resulting in a noise-reduced output signal z.

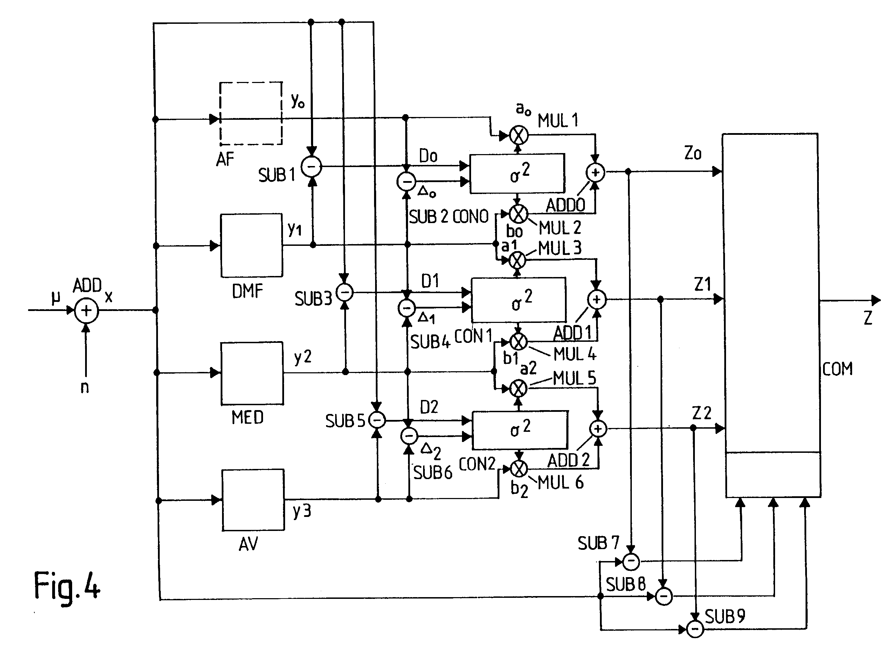

Because the kind of filter MF influences the resulting noise reduction and picture quality, advantageously different filter types can operate in parallel. Then the problem is, how to select the output of the best-fitting filter. In Fig. 4 three filters DMF, MED and AV of different kind are operating, whereby weighted averages of each two consecutive filter outputs are calculated.

Each average is obtained as in Fig. 1 by minimising the squared error $\varepsilon^2$ between the output signal z and the noise-free signal $\mu$. A respective filtered output signal $z_i$, i=0 to 2, is selected by examining the respective errors: the selected branch corresponds then to the minimum error. This method allows switching between filters depending on the statistical properties of the local filtered and unfiltered pictures.

The three restoration filters are:

DMF    - directional median filter;
MED    - median filter;
AV    - average.

The sliding window 30 depicted in Fig. 3 has a size of 5 pixels by 3 lines. As the processing is not on a frame basis but on a field (F1; F2) basis, this size corresponds to a region of 5 by 5 pixels for the interlaced picture (lines of field F1). The directional median filter DMF works as follows: Let $x_{ji}$, j=0 to 2, i=0 to 4, be the pixels taken into account by window 30. The tested filter directions in Fig. 2 are called $d_i$, i=0 to 5. The related gradients are respectively estimated by:

$$g_0 = |x_{00}\text{-}x_{12}|+|x_{24}\text{-}x_{12}|\,;$$
$$g_1 = |x_{01}\text{-}x_{12}|+|x_{23}\text{-}x_{12}|\,;$$
$$g_2 = |x_{02}\text{-}x_{12}|+|x_{22}\text{-}x_{12}|\,;$$
$$g_3 = |x_{03}\text{-}x_{12}|+|x_{21}\text{-}x_{12}|\,;$$
$$g_4 = |x_{04}\text{-}x_{12}|+|x_{20}\text{-}x_{12}|\,;$$
$$g_5 = 1/2^*(|x_{10}\text{-}x_{12}|+|x_{11}\text{-}x_{12}|+|x_{13}\text{-}x_{12}|+|x_{14}\text{-}x_{12}|)\,.$$

The selected direction is given by the smallest gradient. The respective output signals $y_1$ of filter DMF are median values:

$$m_0 = \text{median}\,(x_{00},\, x_{12},\, x_{24})\,;$$
$$m_1 = \text{median}\,(x_{01},\, x_{12},\, x_{23})\,;$$
$$m_2 = \text{median}\,(x_{02},\, x_{12},\, x_{22})\,;$$
$$m_3 = \text{median}\,(x_{03},\, x_{12},\, x_{21})\,;$$
$$m_4 = \text{median}\,(x_{04},\, x_{12},\, x_{20})\,;$$
$$m_5 = \text{median}\,(x_{11},\, x_{12},\, x_{13})\,.$$

If two or more of these directions result in a minimum gradient, the average of the respective signals is taken to generate the output $y_1$. Such multiple minimum gradients appear at less than 1% of pixels.

The output $y_2$ of filter MED is:

$$y_2 = \text{median}\,(x_{ji}) \atop {0 \le i \le 4 \atop 0 \le j \le 2}$$

The output $y_3$ of filter AV is:

$$y_3 = \frac{1}{15} * \sum_{0 \le i \le 4 \atop 0 \le j \le 2} (x_{ji})$$

In Fig. 4 the circuits ADD, DMF, SUB2, CON0, MUL1, MUL2 and ADD0 correspond to the circuits ADD, MF, SUB, CON, MUL1, MUL2 and ADD of Fig. 1. The input of filter DMF is also connected to a second filter MED and to a third filter AV and can also be connected to an additional filter AF which forms the output signal $y_0$ from the noisy input signal x. The input signal x is also fed to a first, a third and a fifth subtractor SUB1, SUB3 and SUB5. The output signal $y_1$, $y_2$ and $y_3$, respectively, of filter DMF, MED and AV, respectively, is subtracted in the subtractor SUB1, SUB2 and SUB3, respectively, from the input signal x. The outputs $D_0$, $D_1$, and $D_2$, respectively, of these subtractors are each connected to a respective control circuit CON0, CON1 and CON2. The difference signal $\Delta_0$, $\Delta_1$ and $\Delta_2$, respectively, calculated in a second, a fourth and a sixth subtractor SUB2, SUB4 and SUB6, respectively, between signals $y_0$ (=x) and $y_1$, $y_1$ and $y_2$, and $y_2$ and $y_3$, respectively, are also fed to the according control circuit CON0, CON1 and CON2.

If filter AF is omitted, SUB1 can also be omitted because $D_0 = \Delta_0$.

The first control circuit CON0 controls the coefficient $a_0$ of a first multiplier MUL1 which multiplies signal $y_0$ and the coefficient $b_0$ of a second multiplier MUL2 which multiplies signal $y_1$. The outputs of these multipliers are added in adder ADD0, forming output signal $z_0$.

The second control circuit CON1 controls the coefficient $a_1$ of a third multiplier MUL3 which multiplies signal $y_1$ and the coefficient $b_1$ of a fourth multiplier MUL4 which multiplies signal $y_2$. The outputs of these multipliers are added in adder ADD1, forming output signal $z_1$.

The third control circuit CON2 controls the coefficient $a_2$ of a fifth multiplier MUL5 which multiplies signal $y_2$ and the

coefficient $b_2$ of a sixth multiplier MUL6 which multiplies signal $y_3$. The outputs of these multipliers are added in adder ADD2, forming output signal $z_2$.

In a seventh, eighth and ninth subtractor SUB7, SUB8 and SUB9, respectively, the difference signals between the according output signals $z_0$, $z_1$ and $z_2$ and the input signal x (error on window) are calculated. These subtractor output signals are used in a fourth control and mixing circuit COM for connecting one of the output signals $z_0$, $z_1$ and $z_2$ with output z, according to the minimum error.

For calculating the minimum error in the four control circuits, the known noise variance $\sigma^2$, as described for Fig. 1, is used. Hard or soft switching can be made in control circuit COM.

The quadratic errors to be minimised in CON0, CON1 and CON2 are for i=0 to 2:

$$\varepsilon_i = 1/N_R * \sum_R (a_i y_i + b_i y_{i+1} - \mu)^2 \tag{1}$$

$$= 1/N_R * \sum_R (z_i - \mu)^2$$

$$= 1/N_R * S_{z_i-\mu, z_i-\mu,}$$

where $N_R$ is the total number of pixels in the region R which corresponds to the sliding window 30. The notation $\mathbf{S}_{u,v}$ is used to designate a sum of squares over the region R and is defined as:

$$Su,v = \sum_R u(k,l)v(k,l),$$

where k and l are elements of R and u and v stand either for x, $Y_i$, $z_i$ or $\mu$. $\mu$ is not known so that $\mathbf{S}y_i,\mu$ cannot be computed in such a way. Instead, use is made of an a prior knowledge of the noise statistics.

It is assumed for simplicity that $a_i$ and $b_i$ are constant over the region R. Then (equation 1):

$$N_R \varepsilon_i = a_i^2 \sum_R y_i^2 + b_i^2 \sum_R y_{i+1}^2 + \sum_R \mu^2 + 2a_i b_i \sum_R y_i y_{i+1} - 2a_i \sum_R y_i \mu - 2b_i \sum_R y_{i+1} \mu$$

$$= a_i^2 Sy_i,y_i + b_i^2 Sy_{i+1},y_{i+1} + S\mu,\mu + 2a_i b_i Sy_i,y_{i+1} - 2a_i Sy_i,\mu - 2b_i Sy_{i+1},\mu$$

The constraint is $a_i + b_i = 1$. The minimisation with this constraint leads to the following system of equations:

$$a_i Sy_i,y_i + b_i Sy_i,y_{i+1} + \lambda_i = Sy_i,\mu$$

$$a_i Sy_i,y_{i+1} + b_i Sy_{i+1},y_{i+1} + \lambda_i = Sy_{i+1},\mu$$

$$a_i + b_i = 1,$$

where $\lambda_i$ is a Lagrange multiplier.

The solution is:

$$a_i = ( Sy_i,\mu - Sy_{i+1},\mu - Sy_i,y_{i+1} + Sy_{i+1},y_{i+1})/\Delta_i$$

$$b_i = (-Sy_i,\mu + Sy_{i+1},\mu - Sy_i,y_{i+1} + Sy_i,y_i )/\Delta_i$$

where $\Delta_i = Sy_i,y_i - 2Sy_i,y_{i+1} + Sy_{i+1},y_{i+1} = Sy_i-y_{i+1},y_i-y_{i+1}$

Because $\mu = x - n$,

$$Sy_i,\mu = Sy_i,x - Sy_i,n = Sx,y_i - S\mu_i',n - Sn_i',n = Sx,y_i - \rho_i \sigma^2$$

where for each filter $F_i$: $\mu_i'$ is the filtered noise free signal, $n_i'$ is the filtered noise, $\sigma^2 = E(n^2(k, l))$ is the known noise variance and $\rho_i = E(n(k, l)n_i'(k, l))$ is the residual noise correlation coefficient after filtering with $F_i$ (i.e. $\rho=1$: no filtering; $\rho=0$: full filtering, no noise left).

The assumption of stationary noise allows here easy estimation of these coefficients $\rho_i$. But if they are known for another kind of noise, it is possible to extend the filter to less restrictive conditions.

Using these coefficients, $a_i$ and $b_i$ can be estimated to:

$$a_i = ( Sx,y_i - Sx,y_{i+1} - Sy_i,y_{i+1} + Sy_{i+1},y_{i+1} - \rho_i\sigma^2 + \rho_{i+1}\sigma^2)/\Delta_i$$

$$b_i = (-Sx,y_i + Sx,y_{i+1} - Sy_i,y_{i+1} + Sy_i,y_i + \rho_i\sigma^2 - \rho_{i+1}\sigma^2)/\Delta_i$$

or

$$a_i = (Sx-y_{i+1},y_i-y_{i+1} - \sigma^2(\rho_i - \rho_{i+1}))/Sy_i-y_{i+1},y_i-y_{i+1}$$

$$b_i = (Sy_i-x,y_i-y_{i+1} + \sigma^2(\rho_i - \rho_{i+1}))/Sy_i-y_{i+1},y_i-y_{i+1}$$

Therefore $a_i$ and $b_i$ are known once the correlation term $Sx-y_{i+1},y_i-y_{i+1}$ has been computed within the control circuits CON0, CON1 and CON2 for the current position of the window 30. The output signals $D_0$, $D_1$ and $D_2$, respectively, of the according subtractors SUB1, SUB2 and SUB3 are used for computing these correlation terms. For good stability of the system it is required that $z_i$ is always between $y_i$ and $y_{i+1}$, i.e. $0 \leq a_i \leq 1$.

For selecting in control and mixing circuit COM the optimum filter branch, it is possible to derive from the values of a and b the quadratic errors:

$$N_R \varepsilon_i = Sz_i-\mu,z_i-\mu = Sz_i,z_i - 2Sz_i,\mu + S\mu,\mu$$

where

$$S\mu,\mu = Sx-n,\mu = Sx,\mu - Sn,\mu = Sx,x - Sx,n = Sx,x - Sn,n - S\mu,n = Sx,x - \sigma^2$$

and

$$Sz_i,\mu = Sa_iy_i+b_iy_{i+1},\mu = a_iSy_i,\mu + b_iSy_{i+1},\mu = a_iSx,y_i - a_i\rho_i\sigma^2 + b_iSx,y_{i+1} - b_i\rho_{i+1}\sigma^2 = Sx,z_i - \sigma^2(a_i\rho_i + b_i\rho_{i+1}).$$

Therefore

$$N_R \varepsilon_i = Sz_i,z_i - 2Sx,z_i + 2\sigma^2(a_i\rho_i + b_i\rho_{i+1}) + Sx,x - \sigma^2 = Sz_i-x,z_i-x + \sigma^2(2a_i\rho_i + 2b_i\rho_{i+1}-1).$$

The correction term $e_i = \sigma^2(2a_i\rho_i + 2b_i\rho_{i+1}-1)$ can be explained by the fact that the more a given filter smooths the picture, the higher the term $Sz_i-x,z_i-x$ will be. Therefore, before the terms generated by filters of different efficiencies can be compared, they must be compensated by a specific kind of function.

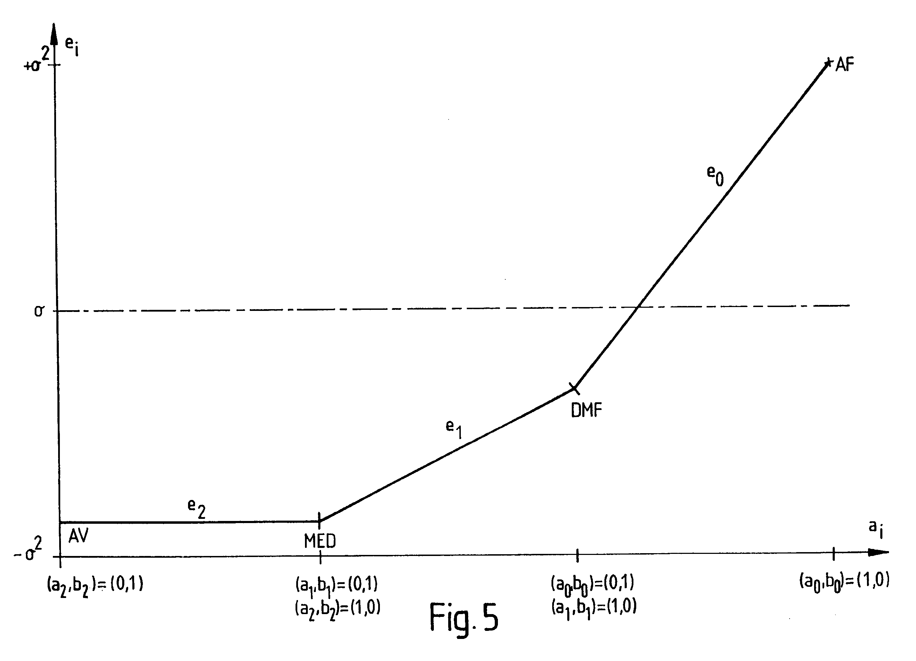

The graph of this function is given in Fig. 5 to illustrate this effect when using the current filter type (AV, MED, DMF, AF) parameters. The correction term $e_i$ is shown in relation to coefficient $a_i$.

The filter AV of type 'average' is well suited for plain areas. The two median filters DMF and MED preserve the edges and a good resolution.

To improve the contrast, enhancement processing can be implemented after the noise reduction processing.

If the window 30 is enlarged, also other picture degradations can be reduced, for example blurs and stripes.

Advantageously due to field processing no blurs are introduced on moving objects.

In order to reduce the complexity and the costs of the hardware implementation it is possible to modify the described filters in the following way:

*   the size of the window for error estimation can be reduced to 5 pixels by 1 line: therefore no additional line memories will be needed (only 2 line memories for the input filters);

* filter DMF can be a directional median filter with only four directions instead of six: $d_0$, $d_2$, $d_4$ and $d_5$;
* filter MED can be a median with a window of three pixels by three lines;
* limitation of the number of bits for the computation of the weighting coefficients (4 bits, for example).

These simplifications have the following influences on the processed pictures:

* if the size of the estimation window is smaller, the simplified filter will tend to filter more than the non simplified one, particularly when there are local horizontal line structures, because no care is taken of the previous and following lines even if they are very different in their local structure;
* simplifications of the input filters do not create too many degradations on the output signal since the filtering is adaptive and always the best solution between the three outputs $z_0$, $z_1$ and $z_2$ is chosen;
* the reduction of the number of bits of the weighting coefficients creates no significant loss of accuracy: 1 or 2 units for an amplitude range of 256.

The big advantage of this new filter is to allow with very few memories and simple hardware implementation a noise filtering that is adaptive simultaneously locally and globally.
Because of this double ability of adaptation the filtering is optimised even with simple filters at the input.
The inventive noise reduction can be used in any video or audio processing devices, e.g. TV receivers and VCR's.

**Claims**

1. Method for noise reduction of a digital video signal, comprising the following steps:

   filtering the noisy input video signal (x) in parallel in at least three branches of different filter types (DMF, MED, AV), whereby in a first of said branches no filtering may be performed;
   estimating for each branch within a sliding window (30) in a current picture of said digital video signal a local noise value by minimising the quadratic errors between the pixel difference values of a calculated weighted average signal (Z0, Z1, Z2) of the filter output signals (y0, y1, y2, y3) of two consecutive branches and the input video signal (x), wherein for calculating the weights for the weighted average signal (Z0, Z1, Z2) in each branch (a0, b0; a1, b1; a2, b2) a global noise value ($\sigma$2) and a local noise value for the branch are taken into account and first pixel difference signals (D0, D1, D2, D3) between the input signal (x) and the filter output signals (y0, y1, y2, y3) are calculated and further pixel difference signals ($\Delta$0, $\Delta$1, $\Delta$2) between the filter output signals (y0, y1, y2, y3) of each two consecutive branches are calculated;
   forming the final noise reduction output signal (Z) from the weighted averages of the branches, depending on the minimum error between the weighted averages of the branches compared to said input video signal (x).

2. Method according to claim 1, wherein when comparing said minimum error, a correction term related to the respective filter characteristic is added to each of the branch errors.

3. Method according to claim 1 or 2, wherein the sum of the two weighting factors (a0, b0; a1, b1; a2, b2) for said weighted averages is 1.

4. Method according to one of claims 1 to 3, wherein the respective one (a0, a1, a2) of each two (a0, b0; a1, b1; a2, b2) weighting factors for said weighted average is in the range 0 to 1.

5. Method according to one of claims 1 to 4, wherein at minimum two of the following filter characteristics are used in said branches: directional median filter (DMF), median filter (MED), average (AV), whereby for said directional median filter at minimum four directions (d0-d5) are evaluated in said sliding window (30).

6. Method according to one of claims 1 to 5, wherein said sliding window (30) has a size of five pixels by one to five lines when related to a frame basis.

7. Digital video signal noise reduction apparatus, comprising:

   a first filter (DMF), a second filter (MED) and a third filter (AV) of different type and being supplied by a common input video signal (x) and;

a first control circuit (CON0) controlling the weighting values (a0, b0) of a first multiplier (MUL1) operating on said input video signal (x) and a second multiplier (MUL2) operating on the output signal (y1) of said first filter (DMF) , whereby the outputs of these multipliers are combined in first adding means (ADD0) to provide a first weighted sum output signal;

a second control circuit (CON1) controlling the weighting values (a1, b1) of a third multiplier (MUL3) operating on the output signal (y1) of said first filter (DMF) and a fourth multiplier (MUL4) operating on the output signal (y2) of said second filter, whereby the outputs of the third and the fourth multiplier are combined in second adding means (ADD1) to provide a second weighted sum output signal;

a third control circuit (CON2) controlling the weighting values (a2, b2) of a fifth multiplier (MUL5) operating on the output signal (y2) of said second filter (MED) and a sixth multiplier (MUL6) operating on the output signal (y3) of said third filter (AV), whereby the outputs of the fifth and the sixth multiplier are combined in third adding means (ADD2) to provide a third weighted sum output signal;

first subtraction means (SUB2) which feed the difference signal ($\Delta$0) between said input video signal (x) and the output signal (y1) of said first filter (DMF) to said first control circuit (CON0);

second subtraction means (SUB3) which feed the difference signal (D1) between said input video signal (x) and the output signal (y1) of said second filter (MED) to said second control circuit (CON1);

third subtraction means (SUB4) which feed the difference signal ($\Delta$1) between the output signal (y1) of said first filter (DMF) and the output signal (y2) of said second filter (MED) to said second control circuit (CON1);

fourth subtraction means (SUB5) which feed the difference signal (D2) between said input video signal (x) and the output signal (y3) of said third filter (AV) to said third control circuit (CON2);

fifth subtraction means (SUB6) which feed the difference signal ($\Delta$2) between the output signal (y2)of said second filter (MED) and the output signal (y3) of said third filter (AV) to said third control circuit (CON2);

further subtraction means (SUB7, SUB8, SUB9) which feed the respective difference signals between said input video signal (x) and the output signals of said first, second and third adding means ( ADD0, ADD1, ADD2) to a control and mixing circuit (COM) which selects first, second and third sum output signals (z0, z1, z2) from said first, second and third adding means according to the minimum error derived from the output signals of said further subtraction means and according to a global noise variance value ($\sigma$2),

whereby for each of the branches said weighting values (a0,b0; a1,b1; a2,b2) being calculated in said first, second and third control circuit (CON0, CON1, CON2) are derived from error signals calculated in the respective control circuit from said difference signals (D0,$\Delta$0; D1,$\Delta$1; D2,$\Delta$2) from said global noise variance value ($\sigma$2).

8. Apparatus according to claim 7, wherein said first filter (DMF) is a directional median filter wherein at minimum four directions (d0-d5) are evaluated and said second filter (MED) is a median filter and said third filter (AV) is an averaging filter.

**Patentansprüche**

1. Verfahren zur Rauschverminderung eines digitalen Videosignals, umfassend die folgenden Schritte:

Filtern des rauschbehafteten Video-Eingangssignals (x) parallel in wenigstens drei Zweigen von verschiedenen Filter-Typen (DMF, MED, AV), wobei in einem ersten der Zweige keine Filterung ausgeführt werden muß; Abschätzen eines örtlichen Rauschwertes für jeden Zweig innerhalb eines gleitenden Fensters (30) in einem gegenwärtigen Bild des digitalen Videosignals durch Minimierung der quadratischen Fehler zwischen den Pixel-Differenzwerten eines berechneten gewichteten Durchschnitts-Signals (Z0, Z1, Z2) der Filter-Ausgangssignale (y0, y1, y2, y3) von zwei aufeinanderfolgenden Zweigen und dem Eingangs-Videosignal (x), wobei zur Berechnung der Wichtungen für das gewichtete Durchschnittssignal (Z0, Z1, Z2) in jedem Zweig (a0, b0; a1, b1; a2, b2) ein globaler Rauschwert ($\sigma^2$) und ein örtlicher Rauschwert für den Zweig in Betracht gezogen werden und erste Pixel-Differenzsignale D0, D1, D2, D3) zwischen dem Eingangssignal (x) und den Filter-Ausgangssignalen (y0, y1, y2, y3) berechnet werden und weitere Pixel-Differenzsignale ($\Delta$0, $\Delta$1, $\Delta$2) zwischen den Filter-Ausgangssignalen (y0, y1, y2, y3) von jeden zwei aufeinanderfolgenden Zweigen berechnet werden; Bilden des endgültigen Rauschverminderungs-Ausgangssignals (Z) aus den gewichteten Durchschnitten der Zweige in Abhängigkeit von dem minimalen Fehler zwischen den gewichteten Durchschnitten der Zweige im Vergleich zu dem Video-Eingangssignal (x).

2. Verfahren nach Anspruch 1, bei dem beim Vergleich des minimalen Fehlers jedem Zweigfehler ein auf die entsprechende Filter-Charakteristik bezogener Korrekturterm hinzugefügt wird.

3. Verfahren nach Anspruch 1 oder 2, bei dem die Summe der beiden Wichtungsfaktoren (a0, b0; a1, b1; a2, b2) für die gewichteten Durchschnitte gleich 1 ist.

4. Verfahren nach einem der Ansprüche 1 bis 3, bei dem der entsprechende eine (a0, a1, a2) von jeden zwei Wichtungsfaktoren (a0, b0 a1, b1; a2, b2) für den gewichteten Durchschnitt im Bereich von 0 bis 1 liegt.

5. Verfahren nach einem der Ansprüche 1 bis 4, bei dem wenigstens zwei der folgenden Filter-Charakteristiken in den Zweigen verwendet werden: Richtungs-Median-Filter (DMF), Median-Filter (MED), Durchschnitt (AV), wobei für das Richtungs-Median-Filter wenigstens vier Richtungen (d0 - d5) in dem gleitenden Fenster (30) abgeschätzt werden.

6. Verfahren nach einem der Ansprüche 1 bis 5, bei dem das gleitende Fenster (30) bezogen auf eine Vollbild-Basis eine Größe von fünf Pixeln mal ein bis fünf Zeilen hat.

7. Vorrichtung zur Rauschverminderung eines digitalen Videosignals umfassend:

ein erstes Filter (DMF), ein zweites Filter (MED) und ein drittes Filter (AV) von unterschiedlichem Typ, wobei den Filtern ein gemeinsames Video-Eingangssignal (x) zugeführt wird;

eine erste Steuerschaltung, die die Wichtungswerte (a0, b0) einer ersten Multiplikationsschaltung (MUL1), die auf das Eingangs-Videosignal (x) einwirkt, und einer zweiten Multiplikationsschaltung (MUL2), die auf das Ausgangssignal (y1) des ersten Filters (DMF) einwirkt, steuert, wobei die Ausgänge dieser Multiplikationsschaltungen in ersten Addiermitteln (ADD0) kombiniert werden, um ein erstes gewichtetes Summen-Ausgangssignal zu liefern;

eine zweite Steuerschaltung (CON1), die die Wichtungswerte (a1, b1) einer dritten Multiplikationsschaltung (MUL3), die auf das Ausgangssignal (y1) des ersten Filters (DMF) einwirkt, und einer vierten Multiplikationsschaltung (MUL4), die auf das Ausgangssignal (y2) des zweiten Filters einwirkt, steuert, wobei die Ausgänge der dritten und vierten Multiplikationsschaltung in zweiten Addiermitteln (ADD1) addiert werden, um ein zweites gewichtetes Summen-Ausgangssignal zu liefern;

eine dritte Steuerschaltung (CON2), die die Wichtungswerte (a2, b2) einer fünften Multiplikationsschaltung (MUL5), die auf das Ausgangssignal (y2) des zweiten Filters (MED) einwirkt, und einer sechsten Multiplikationsschaltung (MUL6), die auf das Ausgangssignal (y3) des dritten Filters (AV) einwirkt, steuert, wobei die Ausgänge der fünften und sechsten Multiplikationsschaltung in dritten Addiermitteln (ADD2) kombiniert werden, um ein drittes gewichtetes SummenAusgangssignal zu liefern;

erste Subtraktionsmittel (SUB2), die das Differenzsignal ($\Delta 0$) zwischen dem Video-Eingangssignal (x) und dem Ausgangssignal (y1) des ersten Filters (DMF) der ersten Steuerschaltung (CON0) zuführen;

zweite Subtraktionsmittel (SUB3), die das Differenzsignal (D1) zwischen dem Video-Eingangssignal (x) und dem Ausgangssignal (y1) des zweiten Filters (MED) der zweiten Steuerschaltung (CON1) zuführen;

dritte Subtraktionsmittel (SUB4), die das Differenzsignal ($\Delta 1$) zwischen dem Ausgangssignal (y1) des ersten Filters (DMF) und dem Ausgangssignal (y2) des zweiten Filters (MED) der zweiten Steuerschaltung (CON1) zuführen;

vierte Subtraktionsmittel (SUB5), die das Differenzsignal (D2) zwischen dem Video-Eingangssignal (x) und dem Ausgangssignal (y3) des dritten Filters (AV) der dritten Steuerschaltung (CON2) zuführen;

fünfte Subtraktionsmittel (SUB6), die das Differenzsignal ($\Delta 2$) zwischen dem Ausgangssignal (y2) des zweiten Filters (MED) und dem Ausgangssignal (y3) des dritten Filters (AV) der dritten Steuerschaltung (CON2) zuführen;

weitere Subtraktionsmittel (SUB7, SUB8, SUB9), die die entsprechenden Differenzsignale zwischen dem Video-Eingangssignal (x) und den Ausgangssignalen der ersten, zweiten und dritten Addiermittel (ADD0, ADD1, ADD2) einer Steuer- und Mischschaltung (COM)zuführen, die erste, zweite und dritte Summen-Ausgangssignale (z0, z1, z2) aus den ersten, zweiten und dritten Addiermitteln gemäß dem minimalen Fehler auswählen, der von den Ausgangssignalen der weiteren Subtraktionsmittel und gemäß einem globalen Rausch-Varianzwert ($\sigma 2$) abgeleitet wird;

wobei für jeden der Zweige die Wichtungswerte (a0, b0; a1, b1; a2, b2), die in der ersten, zweiten und dritten Steuerschaltung (CON0, CON1, CON2) berechnet werden, von den Fehlersignalen abgeleitet werden, die in der entsprechenden Steuerschaltung aus den Differenzsignalen (D0, $\Delta 0$; D1, $\Delta 1$; D2, $\Delta 2$) aus dem globalen Rausch-Varianzwert ($\sigma 2$) berechnet werden.

8. Vorrichtung nach Anspruch 7, bei der das erste Filter (DMF) ein Richtungs-Median-Filter ist, wobei wenigstens vier Richtungen (d0 - d5) abgeschätzt, werden, und bei der das zweite Filter (MED) ein Median-Filter und das dritte Filter (AV) ein den Durchschnitt bildendes Filter ist.

**Revendications**

1. Méthode de réduction de bruit d'un signal vidéo numérique, comprenant les étapes suivantes :

   filtrage du signal vidéo d'entrée bruyant (x) en parallèle dans au moins trois branches de types de filtres différents (DMF, MED, AV), par lequel dans une première desdites branches aucun filtrage ne peut être effectué ; estimation pour chaque branche à l'intérieur d'une fenêtre mobile (30) dans une image en cours dudit signal vidéo numérique d'une valeur de bruit locale en minimisant les erreurs quadratiques entre les valeurs de différence d'éléments d'image d'un signal moyen pondéré calculé (Z0, Z1, Z2) des signaux de sortie de filtres (y0, y1, y2, y3) de deux branches consécutives et du signal vidéo d'entrée (x), dans laquelle pour calculer les poids du signal moyen pondéré (Z0, Z1, Z2) dans chaque branche (a0, b0 ; a1, b1 ; a2, b2) une valeur de bruit globale ($\sigma^2$) et une valeur de bruit locale de la branche sont prises en compte et des premiers signaux de différence d'éléments d'image (D0, D1, D2, D3) entre le signal d'entrée (x) et les signaux de sortie de filtres (y0, y1, y2, y3) sont calculés et d'autres signaux de différence d'éléments d'image ($\Delta 0$, $\Delta 1$, $\Delta 2$) entre les signaux de sortie de filtres (y0, y1, y2, y3) de chaque deux branches consécutives sont calculés ; formation du signal de sortie de réduction de bruit final (Z) à partir des moyennes pondérées des branches, en fonction de l'erreur minimum entre les moyennes pondérées des branches en comparaison audit signal vidéo d'entrée (x).

2. Méthode selon la revendication 1, dans laquelle lors de la comparaison de ladite erreur minimum, un terme de correction lié à la caractéristique de filtre respective est ajouté à chacune des erreurs de branche.

3. Méthode selon la revendication 1 ou 2, dans laquelle la somme des deux facteurs de pondération (a0, b0 ; a1, b1 ; a2, b2) desdites moyennes pondérées est 1.

4. Méthode selon l'une quelconque des revendications 1 à 3, dans laquelle ledit facteur respectif (a0, a1, a2) de chaque deux facteurs de pondération (a0, b0 ; a1, b1 ; a2, b2) pour ladite moyenne pondérée se situe dans la gamme de 0 à 1.

5. Méthode selon l'une quelconque des revendications 1 à 4, dans laquelle au minimum deux des caractéristiques de filtre suivantes sont utilisées dans lesdites branches : filtre médian d'aiguillage directionnel (DMF), filtre médian (MED), moyenne (AV), si bien que pour ledit filtre médian d'aiguillage directionnel au minimum quatre directions (d0 à d5) sont évaluées dans ladite fenêtre mobile (30).

6. Méthode selon l'une quelconque des revendications 1 à 5, dans laquelle laite fenêtre mobile (30) a une taille de cinq éléments d'image pour une à cinq lignes dans le cas d'une opération d'image complète par image complète.

7. Appareil de réduction de bruit de signal vidéo numérique, comprenant :

   un premier filtre (DMF), un deuxième filtre (MED) et un troisième filtre (AV) de types différents et recevant un signal vidéo d'entrée commun (x) et ; un premier circuit de commande (CON0) qui commande les valeurs de pondération (a0, b0) d'un premier multiplicateur (MUL1) fonctionnant sur ledit signal vidéo d'entrée (x) et d'un deuxième multiplicateur (MUL2) fonctionnant sur le signal de sortie (y1) dudit premier filtre (DMF), si bien que les sorties de ces multiplicateurs sont combinées dans un premier moyen d'addition (ADD0) en vue de fournir un premier signal de sortie de somme pondéré ; un deuxième circuit de commande (CON1) qui commande les valeurs de pondération (a1, b1) d'un troisième multiplicateur (MUL3) fonctionnant sur le signal de sortie (y1) dudit premier filtre (DMF) et d'un quatrième multiplicateur (MUL4) fonctionnant sur le signal de sortie (y2) dudit deuxième filtre, si bien que les sorties des troisième et quatrième multiplicateurs sont combinées dans un deuxième moyen d'addition (ADD1) en vue de fournir un deuxième signal de sortie de somme pondéré ; un troisième circuit de commande (CON2) qui commande les valeurs de pondération (a2, b2) d'un cinquième multiplicateur (MUL5) fonctionnant sur le signal de sortie (y2) dudit deuxième filtre (MED) et d'un sixième multiplicateur (MUL6) fonctionnant sur le signal de sortie (y3) dudit troisième filtre (AV), si bien que les sorties des cinquième et sixième multiplicateurs sont combinées dans un troisième moyen d'addition (ADD2) en vue de fournir un troisième signal de sortie de somme pondéré ; un premier moyen de soustraction (SUB2) qui passe le signal de différence ($\Delta 0$) entre ledit signal vidéo d'entrée (x) et le signal de sortie (y1) dudit premier filtre (DMF) audit premier circuit de commande (CON0) ;

un deuxième moyen de soustraction (SUB3) qui passe le signal de différence (D1) entre ledit signal vidéo d'entrée (x) et le signal de sortie (y1) dudit deuxième filtre (MED) audit deuxième circuit de commande (CON1)

un troisième moyen de soustraction (SUB4) qui passe le signal de différence ($\Delta$1) entre le signal de sortie (y1) dudit premier filtre (DMF) et le signal de sortie (y2) dudit deuxième filtre (MED) audit deuxième circuit de commande (CON1) ;

un quatrième moyen de soustraction (SUB5) qui passe le signal de différence (D2) entre ledit signal vidéo d'entrée (x) et le signal de sortie (y3) dudit troisième filtre (AV) audit troisième circuit de commande (CON2) ;

un cinquième moyen de soustraction (SUB6) qui passe le signal de différence ($\Delta$2) entre le signal de sortie (y2) dudit deuxième filtre (MED) et le signal de sortie (y3) dudit troisième filtre (AV) audit troisième circuit de commande (CON2) ;

d'autres moyens de soustraction (SUB7, SUB8, SUB9) qui passent les signaux de différence respectifs entre ledit signal vidéo d'entrée (x) et les signaux de sortie desdits premier, deuxième et troisième moyens d'addition (ADD0, ADD1, ADD2) à un circuit de commande et de mixage (COM) qui sélectionne des premier, deuxième et troisième signaux de sortie de somme (z0, z1, z2) à partir desdits premier, deuxième et troisième moyens d'addition conformément à l'erreur minimum dérivée des signaux de sortie desdits autres moyens de soustraction et conformément à une valeur de variance de bruit globale ($\sigma^2$),

si bien que pour chacune des branches lesdites valeurs de pondération (a0,b0 ; a1,b1 ; a2,b2) étant calculées dans lesdits premier, deuxième et troisième circuits de commande (CON0, CON1, CON2) sont dérivées à partir de signaux d'erreur calculés dans le circuit de commande respectif à partir desdits signaux de différence (D0,$\Delta$0 ; D1,$\Delta$1 ; D2,$\Delta$2) à partir de ladite valeur de variance de bruit globale ($\sigma^2$).

8. Appareil selon la revendication 7, dans lequel ledit premier filtre (DMF) est un filtre médian d'aiguillage directionnel dans lequel au moins quatre directions (d0 à d5) sont évaluées et ledit deuxième filtre (MED) est un filtre médian et ledit troisième filtre (AV) est un filtre intégrateur.

Fig.1

Fig.2

Fig.3

Fig.4

EP 0 588 181 B1

Fig. 5